Europäisches Patentamt

European Patent Office

Office européen des brevets

(19)

(11) Numéro de publication : **0 147 326**
**B1**

(12)

# FASCICULE DE BREVET EUROPÉEN

(45) Date de publication du fascicule du brevet :
04.05.88

(21) Numéro de dépôt : **84402704.5**

(22) Date de dépôt : **21.12.84**

(51) Int. Cl.⁴ : **H 03 H 17/06,** H 03 H 17/04,
H 03 H 17/08

(54) **Filtre numérique à bande passante et phase variables.**

(30) Priorité : **30.12.83 FR 8321102**

(43) Date de publication de la demande :
**03.07.85 Bulletin 85/27**

(45) Mention de la délivrance du brevet :
**04.05.88 Bulletin 88/18**

(84) Etats contractants désignés :
**DE GB**

(56) Documents cités :
**US-A- 3 993 890**
**1978 IEEE INTERNATIONAL SYMPOSIUM ON CIR-**
**CUITS AND SYSTEMS PROCEEDINGS, New York, 17-**
**19 mai 1978, pages 297-301, IEEE, New York, US; W.K.**
**JENKINS: "A comparison of residue number multi-**
**pliers and 2's-complement multipliers implemented**
**by stored multiplication tables"**

(73) Titulaire : **THOMSON-CSF**
**173, Boulevard Haussmann**
**F-75379 Paris Cédex 08 (FR)**

(72) Inventeur : **Pham van Cang, Luc**
**THOMSON-CSF SCPI 173, bld Haussmann**
**F-75379 Paris Cedex 08 (FR)**

(74) Mandataire : **Lincot, Georges et al**
**THOMSON-CSF SCPI 19, avenue de Messine**
**F-75008 Paris (FR)**

EP 0 147 326 B1

## Description

L'invention concerne un filtre numérique à bande passante et phase variables. Elle s'applique au filtrage des signaux audiofréquences et de télévision ainsi qu'à la réalisation de nombreux dispositifs électroniques comme par exemple les synthétiseurs de fréquences.

Les filtres numériques à bande passante et phase variables trouvent également leur application dans le domaine de l'audiovisuel pour éliminer les défauts qui apparaissent lors des transformations géométriques réalisées avec des mémoires numériques d'images en particulier lors des anamorphoses et compressions qui provoquent des moirés et scintillements sur l'image transformée.

Les filtres numériques utilisés ont généralement des structures de filtres transversaux ou récursifs constitués par des assemblages de circuits multiplicateurs, la variation de la bande passante étant obtenue par pondération des coefficients multiplicateurs des échantillons numériques du signal mémorisés à l'intérieur de registres du filtre.

Typiquement n jeux de coefficients sont généralement utilisés pour obtenir n bandes passantes différentes.

Concurremment à la variation de la bande passante, les filtres numériques correspondant à ce dernier mode d'utilisation ont quelquefois des structures qui autorisent également l'interpolation de m valeurs intermédiaires entre deux échantillons successifs du signal, de sorte que, m × n jeux de coefficients de pondération sont généralement appliqués sur ces filtres ; dans les exemples de réalisation connus n est de l'ordre de 16 et m de l'ordre de 4.

Les structures de filtres numériques réalisés à l'aide de circuits multiplicateurs ont pour principal inconvénient d'être onéreuses.

Il est possible de remédier à cet inconvénient en réalisant des filtres à bande passante et à phase variables selon la technique de recherche en table (1978 IEEE International Symposium on Circuits and Systems Proceedings, May 17-19, 1978 New York pages 297-301). Selon cette technique, des résultats équivalents aux résultats précédemment énoncés peuvent être obtenus en réalisant une table de valeurs numériques mémorisées à l'intérieur d'une mémoire fournissant les valeurs filtrées du signal en fonction des échantillons numériques du signal à filtrer appliqués sur les entrées d'adressage de la mémoire. Cette table peut être indifféremment mémorisée dans une mémoire à lecture seule du type « ROM » ou à lecture-écriture du type « RAM » selon les applications, ROM et RAM étant les abréviations des termes anglo-saxons « Read only memory » et « Random access memory » utilisées pour désigner ces types de mémoire. L'application de cette structure au problème du filtrage des échantillons de signaux numériques n'offre pas de difficulté, il suffit en effet d'appliquer par exemple sur les entrées d'adressage de la mémoire, N bits pour sélectionner $2^N$ filtres, M bits pour sélectionner $2^M$ phases et p × 8 bits pour appliquer les p entrées « signal ». On obtient ainsi par exemple sur les sorties de la mémoire, un signal de sortie codé sur 8 bits correspondant à chaque combinaison d'adresse appliquée sur les entrées d'adressage de la mémoire. Malheureusement cette structure ne peut être réalisée directement lorsque les nombres de bandes passantes, de phases et d'entrées « signal » deviennent importants. En effet, cette technique conduit, par exemple, pour réaliser un filtre à 16 bandes passantes, 4 phases et 3 entrées, à une table composée par 1 000 méga-octets avec trente lignes d'adresses, ce qui manifestement n'est pas techniquement et économiquement réalisable.

Le but de l'invention est de pallier les inconvénients précités.

A cet effet, l'invention a pour objet un filtre numérique à bande passante et phase variables du type dans lequel Q échantillons numériques du signal à filtrer codés sur 2 × q bits sont appliqués successivement au travers de Q — 1 lignes à retard reliées en série et où les valeurs des échantillons retardés pris à la sortie de chacune des lignes à retard sont pondérées par Q coefficients multiplicateurs inférieurs à l'unité avant d'être additionnés, les résultats des additions successives formant une suite d'échantillons représentant le signal numérique filtré caractérisé en ce qu'il comprend des moyens pour partager chaque échantillon retardé en q doublets adjacents de deux bits, des premiers moyens de mémorisation adressés par chacun des doublets pour mémoriser des tables de pondération, chaque table de pondération étant composée des résultats des combinaisons linéaires des poids des doublets pris dans chaque échantillon composés des bits de même rang multiplié par les coefficients multiplicateurs, chaque partie entière d'un résultat trouvé dans une table étant appliquée en même temps que les parties fractionnaires des autres résultats fournis par les autres tables aux entrées d'adressage de deuxièmes moyens de mémorisation, les deuxièmes moyens de mémorisation étant programmés de façon que, le nombre binaire, adressé dans les deuxièmes moyens de mémorisation par les parties entières et fractionnaires des résultats trouvés dans les premiers moyens de mémorisation en fonction des valeurs des Q échantillons du signal à filtrer, ait une valeur égale à la combinaison linéaire des valeurs correspondantes des Q échantillons du signal par les Q coefficients multiplicateurs. Il est à noter que le document US-A-3993980 décrit un filtre numérique de second ordre dans lequel certains résultats de calcul d'une opération arithmétique intermédiaire sont mémorisés et utilisés plusieurs fois dans les opérations d'addition et de retard fournissant d'autres échantillons filtrés.

D'autres caractéristiques et avantages de l'invention apparaîtront également à l'aide de la description qui va suivre faite au regard des dessins annexés qui représentent :

la figure 1 un filtre transversal de l'art antérieur ;

la figure 2 un filtre récursif de l'art antérieur ;

la figure 3 un exemple de réalisation d'un dispositif de filtrage par table ;

la figure 4 un exemple de réalisation d'un filtre numérique fonctionnant suivant la technique de recherche par table, une séparation des fonctions de filtrage et d'interpolation étant réalisée pour diminuer la taille des mémoires composant le filtre ;

la figure 5 une réalisation d'un filtre numérique conduisant à une partition des tables encore plus efficace ;

la figure 6 un mode de réalisation d'un filtre numérique selon l'invention ;

la figure 7 une représentation d'une mise en cascade de deux filtres numériques de l'invention semblables à celui représenté à la figure 6 ;

la figure 8 un mode de réalisation d'une autre structure du filtre numérique réalisée à l'aide de filtres élémentaires de l'invention du type de celui représenté à la figure 6 ;

la figure 9 un autre mode de réalisation d'un filtre numérique utilisé à l'aide de filtres élémentaires de l'invention du type de celui représenté à la figure 6 ;

la figure 10 un exemple de réalisation d'un filtre récursif obtenu par un assemblage de filtres élémentaires du type de celui représenté à la figure 6.

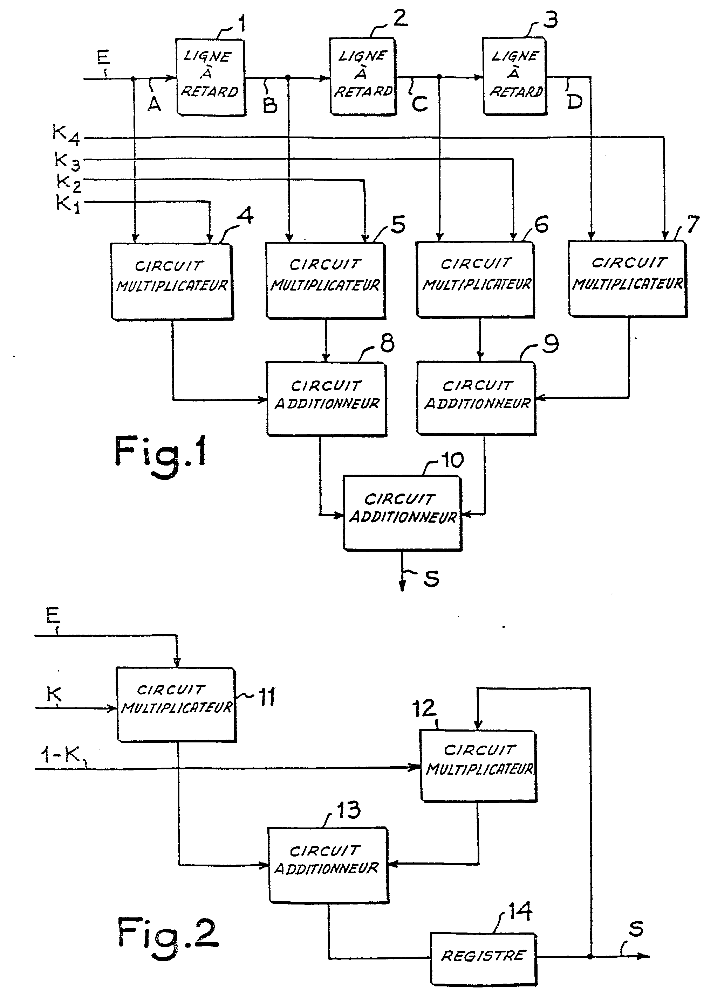

Le filtre numérique représenté à la figure 1 est un filtre transversal de l'art antérieur composé par un ensemble de lignes à retard 1, 2, 3, reliées en série, un ensemble de circuits multiplicateurs 4, 5, 6, 7, et un ensemble d'additionneurs notés respectivement 8, 9 et 10. Chaque échantillon E de signal codé par exemple sur 8 bits est appliqué simultanément sur l'entrée de la première ligne à retard 1 et sur une première entrée du circuit multiplicateur 4. Les sorties des lignes à retard 1, 2 et 3 sont reliées respectivement à une première entrée des circuits multiplicateurs 5, 6 et 7. Sur les deuxièmes entrées des circuits multiplicateurs 4, 5, 6 et 7 sont appliqués respectivement des coefficients de pondération $K_1$, $K_2$, $K_3$ et $K_4$. Les sorties des multiplicateurs 4, 5, 6 et 7 fournissent respectivement le produit des échantillons appliqués sur leurs premières entrées par les coefficients de pondération $K_1$, $K_2$, $K_3$ et $K_4$. Les sorties des multiplicateurs 4 et 5 sont reliées respectivement à une première et une deuxième entrée d'un circuit additionneur 8 et les sorties des circuits multiplicateurs 6 et 7 sont reliées respectivement à une première et une deuxième entrée du circuit additionneur 9. Les sorties des circuits additionneurs 8 et 9 sont reliées respectivement à une première entrée et une deuxième entrée du circuit additionneur 10. Si A désigne la valeur de l'échantillon binaire appliqué sur l'entrée de la première ligne à retard 1 et B, C, D désignent respectivement les valeurs des échantillons obtenus aux sorties des lignes à retard 1, 2 et 3, la sortie du circuit additionneur 10 délivre un signal codé sur 8 bits dont la valeur correspond à la combinaison linéaire des valeurs d'échantillons A, B, C et D par les coefficients de pondération $K_1$, $K_2$, $K_3$ et $K_4$ suivant la relation

$$S = K_1 A + K_2 B + K_3 C + K_4 D .$$

Avec par exemple $K_1 + K_2 + K_3 + K_4 = 1$.

Le schéma représenté à la figure 2 est celui d'un filtre récursif de l'art antérieur composé par deux circuits multiplicateurs 11 et 12, un circuit additionneur 13 et un registre 14. L'échantillon du signal E est appliqué sur une première entrée du circuit multiplicateur 11 qui reçoit sur une deuxième entrée un signal de pondération K. Une première entrée du circuit multiplicateur 12 est reliée à la sortie du registre 14 et la deuxième entrée du circuit multiplicateur 12 reçoit un coefficient multiplicateur égal à 1 — K. Les sorties des deux circuits multiplicateurs 11 et 12 sont reliées respectivement aux première et deuxième entrées du circuit additionneur 13 dont la sortie est reliée à l'entrée du registre 14. Ce filtre permet d'obtenir des échantillons de signaux filtrés à la sortie du registre 14 qui dépendent à chaque instant de la valeur de l'échantillon du signal présent à l'entrée du filtre et de la valeur du signal précédemment filtré. En effet si E désigne la valeur de l'échantilon appliqué à l'entrée du filtre et S(I — 1) la valeur de l'échantillon de signal précédemment filtré, la valeur de l'échantillon filtré correspondant à l'échantillon d'entrée est égale à

$$S(i) = KE + (1 — K) \times S(I — 1) .$$

Dans les structures précédemment décrites la variation de la bande passante des filtres est obtenue généralement en faisant varier la valeur des coefficients $K_1$, $K_2$, $K_3$ et $K_4$ appliqués sur les entrées du filtre.

Dans les techniques audiovisuelles il arrive également que concurremment la variation de bande passante il soit nécessaire d'interpoler des valeurs intermédiaires entre deux échantillons successifs du signal. Généralement le problème se pose pour retrouver trois valeurs intermédiaires ou phases de façon à obtenir une transformation de qualité convenable. n jeux de coefficients sont généralement utilisés permettant ainsi d'obtenir n bandes passantes différentes. La valeur des coefficients est déterminée en temps réel ou est chargée dans une mémoire à lecture seule du type ROM. L'interpolation peut être directement obtenue par le choix des coefficients du filtre transversal à l'aide d'un jeu de m × n coefficients, m désignant le nombre de phases et n désignant le nombre de bandes passantes. Dans les

# 0 147 326

applications connues m est par exemple de l'ordre de 4 et n est de l'ordre de 16. L'inconvénient des structures montrées aux figures 1 et 2 est qu'elles mettent en œuvre des circuits multiplicateurs qui augmentent leur prix de revient.

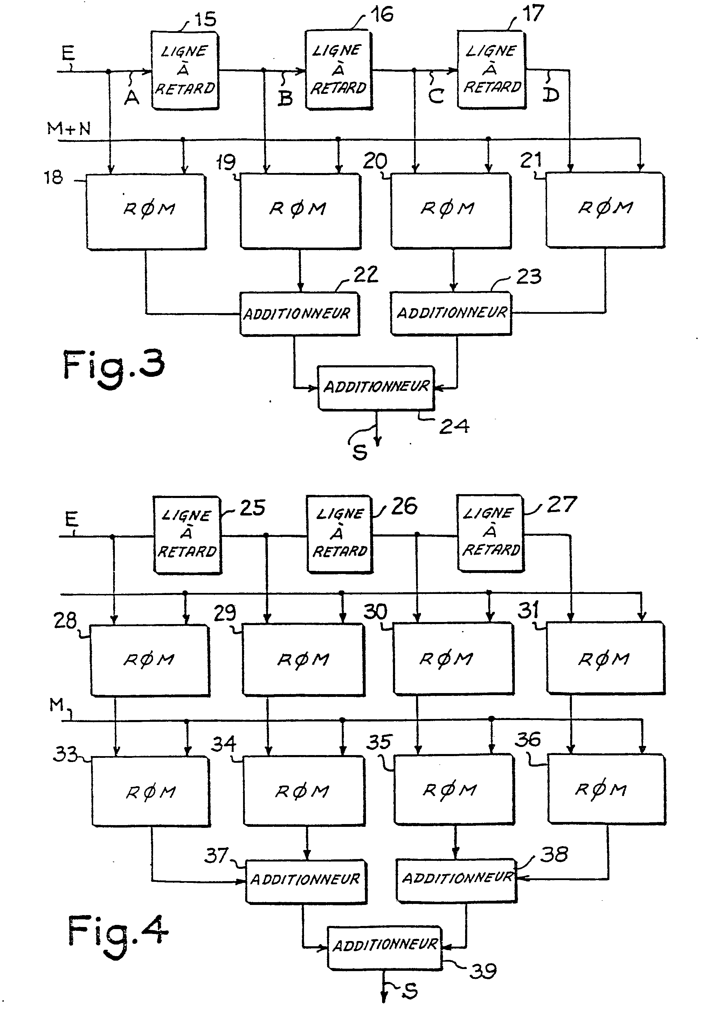

Pour réduire le prix de revient, une première démarche consiste à réaliser des structures de filtres transversaux du type de celui représenté à la figure 3. Le filtre numérique représenté à la figure 3 comprend, un premier ensemble de lignes à retard 15, 16 et 17 reliées en série, un ensemble de quatre mémoires à lecture seule de type ROM notées respectivement de 18 à 21, et un ensemble de circuits additionneurs notés respectivement de 22 à 24. L'échantillon E du signal à filtrer est appliqué sur l'entrée de la ligne à retard et sur une première entrée d'adressage de la mémoire 18. Les sorties des lignes à retard 15, 16 et 17 sont reliées respectivement à une première entrée d'adressage des mémoires 19 à 21. Les mémoires 18 à 21 ont une deuxième entrée d'adressage sur lesquelles sont appliqués les M + N bits de sélection de m phases et de n bandes passantes. Chaque mémoire 18, 19, 20 ou 21 contient une table de pondération de chaque échantillon A, B, C, D appliqué sur sa première entrée d'adressage respectivement par les coefficients $K_1$, $K_2$, $K_3$ et $K_4$. Les valeurs des échantillons pondérés par les tables contenues dans les mémoires 18 et 19 sont additionnées par le circuit additionneur 22. Les valeurs des échantillons pondérés par les tables contenues dans les mémoires 20 et 21 sont additionnées par le circuit additionneur 23. Le circuit additionneur 24 additionne les résultats fournis par les sorties respectives de chaque circuit additionneur 22 et 23, et engendre un signal sur huit bits correspondant à la combinaison linéaire des valeurs des échantillons A, B, C, D présents à un instant donné d'une part à l'entrée de la ligne à retard 15 et d'autre part sur les sorties des lignes à retard 15, 16 et 17 par les coefficients $K_1$, $K_2$, $K_3$ et $K_4$ suivant la relation

$$S = K_1 A + K_2 B + K_3 C + K_4 D \, .$$

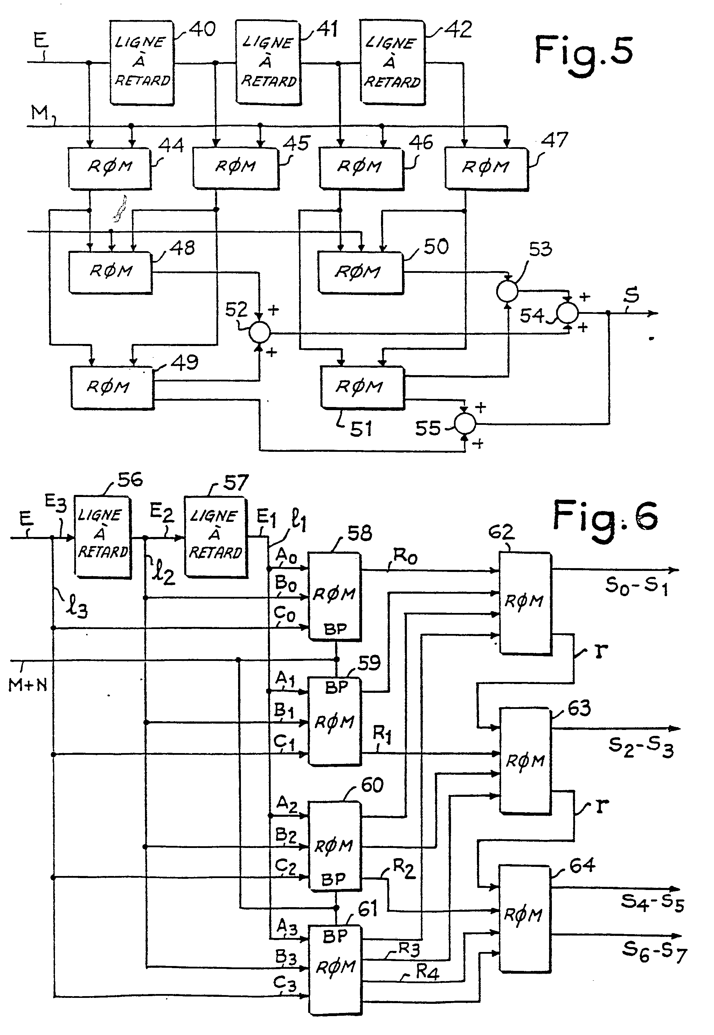

Le schéma de la figure 3 permet la réalisation de quatre tables à quatorze entrées et huit sorties pour former une capacité totale de 64 kilo-octets. Malheureusement, la technologie actuelle des mémoires à lecture seule, rapides, à temps de cycle inférieurs à 74 nano-secondes pour être compatible avec les signaux de télévision, n'offre pas de moyens simples et peu onéreux pour réaliser de telles tables. Une approche selon l'invention permettant de remédier à cet inconvénient est explicité ci-après à l'aide des descriptions des figures 4 et 5.

Le schéma représenté à la figure 4 est celui d'un filtre numérique réalisé à l'aide seulement de mémoires ROM à lecture seule, ayant des capacités de mémoire variant entre 1 à 4 kilo-octets. Ce schéma rend plus facile la réalisation des filtres numériques du type précité. Le filtre de la figure 4 est constitué par un ensemble de lignes à retard 25, 26, 27, un ensemble de mémoires à lecture seule 28 à 31 de 4 kilo-octets et un ensemble de mémoires à lecture seule 33 à 36 de 1 kilo-octets et un ensemble de circuits additionneurs 37 à 39. Les lignes à retard 25, 26, et 27 sont reliées en série. Les échantillons numériques E à filtrer, codés par exemple sur 8 bits, sont appliqués à l'entrée de la ligne à retard 25 et sur une première entrée d'adressage de la mémoire 28. Les mémoires 29 à 31 possèdent chacune une première entrée d'adressage reliée aux sorties respectives des lignes à retard 25 à 27. Les deuxièmes entrées des mémoires 28 à 31 sont adressées par le nombre N de sélections de n bandes passantes pour affecter un coefficient de pondération à chacun des échantillons appliqués sur les premières entrées des mémoires 28 à 31. Les échantillons pondérés obtenus en sortie des mémoires 28, 29 à 31 sont appliqués respectivement sur une première entrée des mémoires 33 à 36 dont une deuxième entrée d'adressage reçoit les bits de sélection de phase M pour adresser des tables d'interpolation contenues dans les mémoires 33 à 36. Les sorties des mémoires 33 et 34 sont appliquées respectivement à une première et une deuxième entrée du circuit additionneur 37 et les sorties des mémoires 35 et 36 sont appliquées respectivement sur une première et une deuxème entrée du circuit additionneur 38. Les sorties des circuits additionneurs 37 et 38 sont appliquées respectivement sur une première entrée et une deuxième entrée du circuit additionneur 39 qui fournit le signal de sortie S du filtre sur une longueur de huit bits.

Une partition encore plus importante de la table de filtrage peut encore être obtenue avec un dispositif du type de celui représenté à la figure 5. Sur cette figure, les échantillons E successifs du signal codé par exemple sur huit bits sont appliqués, après avoir été retardés par les lignes à retard 40 à 42, aux entrées d'adressage d'un ensemble de mémoires 44 à 47 d'une capacité d'1 kilo-octets et contenant des tables d'interpolation. Les valeurs interpolées de chaque échantillon de signal sont appliquées par les sorties des mémoires 44 à 47 aux entrées d'adressage respectives d'un ensemble de mémoires de lecture seule (ROM) 48 à 50. Ces mémoires contiennent les tables de filtrage proprement dites. Chaque octet lu à la sortie des mémoires 44 à 47 est partagé en deux quartets de poids faible et fort. Les quartets de poids faibles sont appliqués sur les entrées d'adressage des mémoires 48 et 50 et les quartets de poids forts sont appliqués sur les entrées d'adressage des mémoires 49 et 51. Chacune des tables contenues dans les mémoires 48 à 51 est formée des résultats des combinaisons linéaires de chaque quartet appliqué sur ses entrées d'adressage par des coefficients multiplicateurs $K_1$, $K_2$, $K_3$ et $K_4$ inférieurs à l'unité. Comme les coefficients multiplicateurs sont inférieurs à l'unité des multiplications effectuées sur les quartets de poids fort donnent un résultat composé par une partie entière et une partie fractionnaire. La partie fractionnaire est composée des mêmes poids binaires que le résultat des combinaisons linéaires des quartets de poids faible obtenus en sortie des mémoires 48 et 50 et est additionnée avec ceux-ci au moyen

4

des circuits additionneurs 52, 53 et 54. Les résultats des combinaisons linéaires effectuées sur les quartets de poids fort et fournis par les mémoires 49 et 51 sont appliqués sur les entrées respectives d'un circuit additionneur 55. Les sorties des circuits additionneurs 54 et 55 forment les sorties du filtre, et engendrent un signal binaire de huit bits, les quatre bits de poids faibles étant obtenus à la sortie de l'additionneur 54 et les quatre bits de poids forts étant obtenus à la sortie de l'additionneur 55. Les filtres des figures 4 et 5 présentent encore l'inconvénient de nécessiter l'utilisation de circuits additionneurs pour recombiner les signaux fournis par les différentes tables mémorisées dans les mémoires du filtre.

Le filtre représenté à la figure 6 permet de s'affranchir des circuits additionneurs précités. Ce filtre comprend des lignes à retard 56 et 57, des moyens de mémorisation de tables de filtrage 58 à 61 couplées par leurs sorties à des deuxièmes moyens de mémorisation de tables d'additions. Les lignes à retard retardent successivement les échantillons E de huit bits appliqués à l'entrée de la ligne 56. Chaque échantillon de huit bits $E_1$, $E_2$, $E_3$, obtenu, est partagé en doublets de deux bits avant d'être appliqué par les lignes $l_1$ à $l_3$ à l'entrée des premiers moyens de mémorisation, les doublets constitués des bits de poids faibles étant appliqués aux entrées d'adressage de la mémoire 58 et les doublets suivants constitués des bits restants étant appliqués dans l'ordre d'importance de leur poids binaires aux entrées d'adressage des mémoires 59 à 61. Suivant ce principe, si l'on désigne par $E_1$ et $E_2$ les échantillons binaires sortant des lignes à retard 57 et 56 et par $E_3$ l'échantillon appliqué à l'entrée de la ligne à retard 56, et en exprimant chaque échantillon sous la forme

$$E1 = \sum_{i=0}^{7} a_i\, 2^i$$

$$E2 = \sum_{i=0}^{7} b_i\, 2^i$$

$$E3 = \sum_{i=0}^{7} c_i\, 2^i$$

la partition en doublets peut être réalisée par les relations :

$$E1 = \sum_{j=0}^{3} A_j\,, \qquad E_2 = \sum_{0}^{3} B_j\,, \qquad E_3 = \sum_{0}^{3} C_j$$

avec

$$A_j = \frac{a \cdot 2^{2j+1}}{2j+1} + \frac{a \cdot 2^{2j}}{2j}$$

$$B_j = \frac{b \cdot 2^{2j+1}}{2j+1} + \frac{b \cdot 2^{2j}}{2j}$$

$$C_j = \frac{c \cdot 2^{2j+1}}{2j+1} + \frac{c \cdot 2^{i}}{2j}$$

En se reportant à la figure 6, les doublets $A_0$, $B_0$ et $C_0$ formés des bits de poids les plus faibles, sont appliqués aux entrées d'adressage de la mémoire 58. Les doublets $A_1$, $B_1$, $C_1$ formés des bits de poids directement supérieurs, sont appliqués aux entrées d'adressage de la mémoire 59. Les doublets $A_2$, $B_2$, $C_2$ sont appliqués aux entrées de la mémoire 60 et les doublets $A_3$, $B_3$, $C_3$ formés les deux bits de poids les plus forts de chaque échantillon sont appliqués aux entrées d'adressage de la mémoire 61. Chacune des tables contenues dans les mémoires 58 à 61 est formée des résultats des combinaisons linéaires des valeurs de chaque doublet appliqué sur ses entrées d'adressage. Si l'on désigne comme précédemment, par $K_0$, $K_1$ et $K_2$ les coefficients tous inférieurs à l'unité de chacune des combinaisons linéaires, chaque résultat $R_0$ à $R_3$ mémorisé dans une table 58 à 61 est obtenu en appliquant la relation matricielle

$$\begin{bmatrix} R_0 \\ R_1 \\ R_2 \\ R_3 \end{bmatrix} = \begin{bmatrix} A_0 & B_0 & C_0 \\ A_1 & B_1 & C_1 \\ A_2 & B_2 & C_2 \\ A_3 & B_3 & C_3 \end{bmatrix} \times \begin{bmatrix} K_0 \\ K_1 \\ K_2 \end{bmatrix}$$

Comme les coefficients multiplicateurs $K_0$, $K_1$, $K_2$ sont choisis, à la manière des exemples précédents, de façon à être inférieurs à l'unité, les multiplications effectuées sur les doublets formés des bits de poids supérieurs aux deux premiers bits de poids faible d'un échantillon, donnent des résultats composés par une partie entière et une partie fractionnaire. Sur la figure 6, les parties entières des résultats $R_0$, $R_1$ et $R_2$ sont lues dans des mémoires 58 à 60 à l'adresse indiquée par les valeurs des doublets présents sur leurs entrées d'adressage et sont appliqués respectivement aux entrées d'adressage des mémoires 62 à 64 constituant les deuxièmes moyens de mémorisation. Les résultats $R_3$ et $R_4$

fournis en provenance de la mémoire 61 sont appliqués en même temps que le résultat $R_2$ sur les entrées d'adressage de la mémoire 64. Les parties fractionnaires des résultats $R_1$ et $R_4$ sont appliquées en fonction de leur poids sur les entrées d'adressage correspondantes des mémoires 62 à 64, les doublets composés des bits de poids les plus faibles étant appliqués aux entrées de la mémoire 62 et les bits de poids supérieurs étant appliqués suivant leur ordre d'importance sur les entrées d'adressage des mémoires 63 et 64. Les mémoires 62 à 64 sont programmées de façon qu'à chaque combinaison d'adresse fournie par les mémoires 58 à 61 corresponde sur leurs sorties juxtaposées un nombre binaire

$$S = \sum_{i=0}^{7} S_i\, 2^i$$

dont la valeur correspond à la combinaison linéaire des échantillons $E_1$, $E_2$, $E_3$ par les coefficients $K_0$, $K_1$, $K_2$ et $K_3$. Dans l'exemple de la figure 6, la mémoire 62 fournit les doublets $S_0$, $S_1$, la mémoire 63 fournit les doublets $S_2$, $S_3$ et la mémoire 64 fournit les doublets $S_4$, $S_5$ et $S_6$, $S_7$.

Naturellement des lignes de report r de retenue sont prévues entre les mémoires 62, 63 et 63 et 64 pour reporter sur les mémoires d'addition toute retenue qui peut être lue dans une table d'addition fournissant l'un des doublets $S_0$, $S_1$, ou $S_2$, $S_3$. Des dispositifs de compensation du temps de propagation des retenues, non représentés comme étant à la portée de l'homme de l'art, pourront éventuellement être ajoutés sur les entrées d'adressage des mémoires 62 à 64.

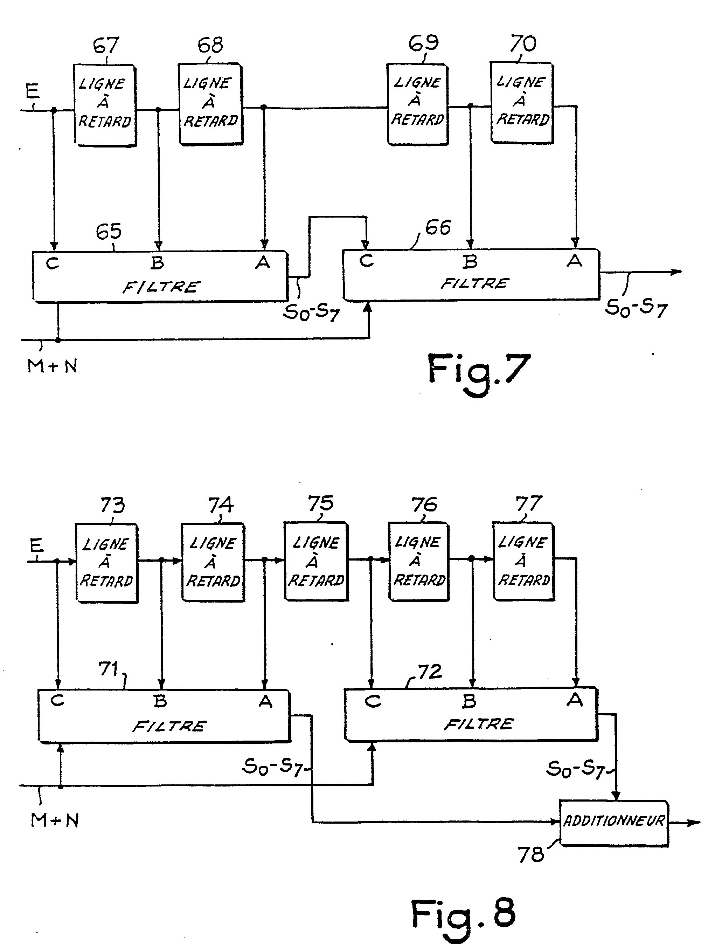

En choisissant pour la réalisation des mémoires 58 à 61 des mémoires ROM à lecture seule de 4 kilo-octets et pour la réalisation des mémoires 62 à 64 des mémoires ROM à lecture seule de 1 kilo-octets, la structure indiquée à la figure 6 permet de réaliser un filtre numérique composé de trois coefficients, seize bandes passantes et quatre phases sélectionnés sur les entrées B et P des mémoires 58 à 61, cette structure pouvant être intégrée de façon modulaire pour pouvoir éventuellement entrer dans la composition de filtres encore plus compliqués du type de ceux représentés aux figures 7 à 10.

Le schéma représenté à la figure 7 représente une combinaison de deux filtres 65 et 66 mis en cascade de type de celui représenté à la figure 6, qui permet de réaliser un filtre à cinq coefficients multiplicateurs. Chaque échantillon est filtré et appliqué simultanément à l'entrée de la ligne à retard 67 et à l'entrée C du premier filtre 65, les sorties des lignes à retard 67 et 68 étant appliquées respectivement sur les entrées B et A du filtre 65 et les sorties des lignes à retard 69 et 70 étant appliquées respectivement sur les entrées B et A du filtre 66. La sortie du filtre 65 transmettant les bits de $S_0$ à $S_7$ est reliée à l'entrée C du filtre 66. Les échantillons filtrés du signal sont obtenus à la sortie du filtre 66.

Le schéma représenté à la figure 8 est celui d'un filtre à six coefficients utilisant deux filtres 71 et 72 du type de celui décrit à la figure 6. Chaque échantillon E du signal à filtrer est appliqué simultanément à l'entrée d'une ligne à retard 73 et à l'entrée C du premier filtre 71. Chaque échantillon du signal est successivement retardé par les lignes à retard 73 à 77. Les sorties des lignes à retard 73 et 74 sont reliées respectivement aux entrées B et A du filtre 71 et les sorties respectives des lignes à retard 75 à 77 sont reliées respectivement aux entrées C et A du filtre 72. Les sorties des filtres 71 et 72 sont reliées respectivement à une première et une deuxième entrée d'un additionneur 78 qui fournit sur sa sortie les échantillons filtrés du signal codé sur huit bits.

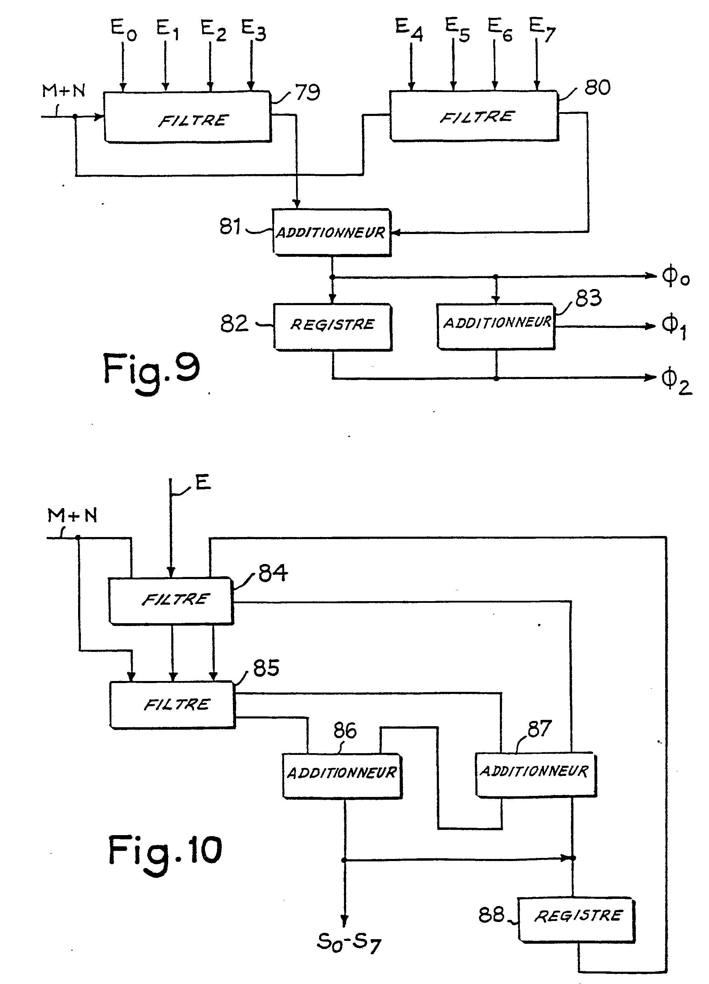

Le filtre représenté à la figure 9 est un filtre à huit coefficients·muni d'un déphaseur linéaire. Il comprend deux filtres 79 et 80 du type de celui représenté à la figure 6. Chaque sortie des filtres 79 et 80 est reliée à une première et une deuxième entrée d'un additionneur 81 dont la sortie est reliée à un registre 82, l'entrée et la sortie du registre 82 étant reliées respectivement à une première et une deuxième entrée d'un additionneur 83 qui permet d'additionner la valeur de l'échantillon sortant de l'additionneur 81 à l'échantillon précédent mémorisé dans le registre 82 pour fournir une valeur d'échantillon égale à la somme des deux échantillons.

La figure 10 représente une structure de filtre récursif obtenu à partir de deux filtres 84 et 85 du type de celle du filtre représenté à la figure 6 et qui permet à partir de deux additionneurs 86 et 87 et d'un registre 88 relié à la sortie de l'additionneur 86 d'obtenir un filtre récursif d'ordre 1.

L'invention n'est pas limitée aux modes de réalisation qui viennent d'être décrits, il va de soi qu'elle s'applique également à d'autres variantes de réalisation qui au lieu de filtrer des signaux formés d'échantillons de 8 bits pourront filtrer des échantillons de 2 q bits où q peut être quelconque. Egalement l'invention n'est pas limitée par le nombre d'échantillon Q qui peuvent être appliqués à l'entrée du filtre. Quel que soit le nombre Q d'échantillons appliqués il est en effet possible d'adapter la structure du filtre représentée à la figure 6 à une structure plus ou moins étendue comportant Q — 1 lignes à retard et Q coefficients.

**Revendications**

1. Filtre numérique à bande passante et phase variables du type dans lequel Q échantillons numériques du signal à filtrer codés sur $2 \times q$ bits sont appliqués successivement au travers de Q — 1 lignes à retard reliées en série et où les valeurs des échantillons retardés pris à la sortie de chacune des lignes à retard sont pondérées par Q coefficients multiplicateurs inférieurs à l'unité avant d'être additionnés, les résultats des additions successives formant une suite d'échantillons représentant le signal numérique filtré caractérisé en ce qu'il comprend des moyens ($I_1$, $I_2$, $I_3$) pour partager chaque échantillon retardé en q doublets adjacents de deux bits, des premiers moyens de mémorisation (58, 59, 60, 61) adressés par chacun des doublets pour mémoriser des tables de pondération, chaque table de pondération étant composée des résultats des combinaisons linéaires des poids des doublets composés des bits de même rang multiplié par les coefficients multiplicateurs, chaque partie entière d'un résultat trouvé dans une table étant appliquée en même temps que les parties fractionnaires des autres résultats fournis par les autres tables aux entrées d'adressage de deuxièmes moyens de mémorisation (62, 63, 64), les deuxièmes moyens de mémorisation étant programmés de façon que, chaque nombre binaire, adressé dans les deuxièmes moyens de mémorisation par les parties entières et fractionnaires des résultats trouvés dans les premiers moyens de mémorisation en fonction des valeurs des Q échantillons du signal à filtrer, ait une valeur égale à la combinaison linéaire des valeurs correspondantes des Q échantillons du signal par les Q coefficients multiplicateurs.

2. Filtre numérique à bande passante et phase variables caractérisé en ce qu'il comprend une pluralité de filtres (65, 66) selon la revendication 1 reliés en cascade.

3. Filtre numérique à bande passante et phase variables caractérisé en ce qu'il comprend une pluralité (71, 72) de filtres selon la revendication 1 dont les sorties des deuxièmes moyens de mémorisation sont reliées ensemble au travers de circuits additionneurs.

4. Utilisation du filtre selon la revendication 4 pour la réalisation d'un filtre récursif.

5. Utilisation du filtre selon la revendication 1 pour la réalisation d'un déphaseur.

## Claims

1. Digital filter with variable pass-band and phase, of the type wherein Q digital samples of the signal to be filtered and coded on 2 × q bits are successively fed through Q — 1 delay lines connected in series, and wherein the delayed sample values taken at the output of each delay line are weighted by Q multiplication coefficients smaller than unity before they are added to each other, the results of successive additions forming a sequence of samples representing the filtered digital signal, characterized in that it comprises means ($I_1$, $I_2$, $I_3$) for dividing each delayed sample into q adjacent two bit doublets, first storing means (58, 59, 60, 61) addressed by each of the doublets to store weighting tables, each weighting table being composed of the results of the linear combinations of the significances of the doublets composed of bits of the same order multiplied by the multiplication coefficients, each integer portion of a result found in a table being applied simultaneously with the fraction portions of the other results supplied by the other tables to the addressing inputs of second storing means (62, 63, 64), the second storing means being programmed in such a manner that each binary number, addressed in the second storing means by the integer and fraction portions of the results found in the first storing means as a function of the values of Q samples of the signal to be filtered, has a value equal to the linear combination of the corresponding values of the Q samples of the signal by the Q multiplication coefficients.

2. Digital filter having variable pass-band and phase, characterized in that it comprises a plurality of filters (65, 66) according to claim 1, connected in cascade.

3. Digital filter having variable pass-band and phase, characterized in that comprises a plurality (71, 72) of filters according to claim 1 wherein the outputs of the second storing means are interconnected through adding circuits.

4. Use of the filter according to claim 4 for realizing a recursive filter.

5. Use of the filter according to claim 1 for realizing a phase shifter.

## Patentansprüche

1. Digitales Filter mit variablem Durchlaßband und variabler Phase, vom Typ, worin Q digitale Abtastproben des zu filternden Signals, die auf 2 × q Bits codiert sind, nacheinander über Q — 1 Verzögerungsleitungen angelegt werden, die in Reihe geschaltet sind, worin die Werte der verzögerten Abtastproben am Ausgang jeder Verzögerungsleitung durch Q Multiplikationskoeffizienten gewichtet sind, die kleiner als eins sind, bevor sie addiert werden, wobei die Ergebnisse der aufeinanderfolgenden Additionen eine Folge von Abtastproben bilden, welche das gefilterte Digitalsignal darstellen, dadurch gekennzeichnet, daß es Mittel ($I_1$, $I_2$, $I_3$) umfaßt, um jede verzögerte Abtastprobe in q benachbarte Zweibit-Dubletts zu unterteilen, erste Speichermittel (58, 59, 60, 61) enthält, die jeweils durch jedes Dublett adressiert werden, um Wichtungstabellen zu speichern, wobei jede Wichtungstabelle zusammengesetzt ist aus den Ergebnissen der Linearkombinationen mit den Wichtungen der Dubletts, die zusammengesetzt sind aus den Bits gleicher Ordnungszahl, multipliziert mit den Multiplikationskoeffizienten, wobei jeder ganzzahlige Teil eines Ergebnisses, das in einer Tabelle gefunden wird, zu gleicher Zeit wie die Bruchteile der anderen Ergebnisse, die von den anderen Tabellen geliefert werden, an die Adressiereingänge von zweiten Speichermitteln (62, 63, 64) angelegt wird, wobei die zweiten Speichermittel so programmiert sind, daß jede Binärzahl, die in den zweiten Speichermitteln durch die ganzzahligen Teile und die Bruchteile der Ergebnisse adressiert wird, die in den ersten Speichermitteln in Abhängigkeit von den Werten der Q Abtastproben des zu filternden Signals gefunden werden, einen Wert aufweist, der gleich der Linearkombination der entsprechenden Werte der Q Abtastproben des Signals mit den Q Multiplikationskoeffizienten ist.

2. Digitales Filter mit variablem Durchlaßband und variabler Phase, dadurch gekennzeichnet, daß es eine Mehrzahl von Filtern (65, 66) nach Anspruch 1 enthält, die in Kaskade geschaltet sind.

3. Digitales Filter mit variablem Durchlaßband und variabler Phase, dadurch gekennzeichnet, daß es eine Mehrzahl von Filtern (71, 72) nach Anspruch 1 enthält, wovon die Ausgänge der zweiten Speichermittel über Addierschaltungen miteinander verbunden sind.

4. Verwendung des Filters nach Anspruch 4 zur Verwirklichung eines rekursiven Filters.

5. Verwendung des Filters nach Anspruch 1 zur Verwirklichung eines Phasenschiebers.

Fig.1

Fig.2

0 147 326

Fig.3

Fig.4

2

Fig.5

Fig.6

3

Fig.7

Fig.8

4

$E_0$ $E_1$ $E_2$ $E_3$ $E_4$ $E_5$ $E_6$ $E_7$

M+N

FILTRE ~79    FILTRE ~80

81 ADDITIONNEUR

$\phi_0$

82 REGISTRE    ADDITIONNEUR ~83

$\phi_1$

$\phi_2$

# Fig.9

E

M+N

FILTRE ~84

FILTRE ~85

86 ADDITIONNEUR    ADDITIONNEUR ~87

# Fig.10

$S_0$-$S_7$

88 REGISTRE

5